# EUROPÄISCHE PATENTSCHRIFT

(11) **EP 0 878 990 B1**
(45) Veröffentlichungstag und Bekanntmachung des Hinweises auf die Patenterteilung: **19.12.2001**
(21) Anmeldenummer: 98250161.1
(22) Anmeldetag: 13.05.1998
(51) Int. Cl.: H05K 5/02, B64G 1/58

(54) **Hitzeschutzmantel für ein elektronisches Gerät**
Heat protective jacket for an electronic device
Chemise de protection contre la chaleur pour un dispositif électronique

(30) Priorität: 17.05.1997 DE 19720842
(43) Veröffentlichungstag der Anmeldung: 18.11.1998
(73) Patentinhaber: Bodenseewerk Gerätetechnik GmbH, 88662 Überlingen (DE)
(72) Erfinder: Messmer, Helmut, 78269 Volkertshausen (DE); Kummle, Wolfgang, 88682 Salem-Beuren (DE)
(74) Vertreter: Weisse, Jürgen, Dipl.-Phys.

(56) Entgegenhaltungen:
- WO-A-93/22814
- DE-B- 1 135 065
- GB-A- 2 151 410
- GB-A- 2 218 719
- GB-A- 2 293 208
- US-A- 4 879 320
- US-A- 4 944 401
- US-A- 5 398 467

## Beschreibung

Die Erfindung betrifft einen Hitzeschutzmantel für ein elektronisches Gerät. Die Erfindung betrifft auch ein hitzegeschütztes elektronisches Gerät in einem Gehäuse, das von einem Hitzeschutzmantel umgeben ist.

Es besteht häufig die Notwendigkeit, ein elektronisches Gerät jedenfalls für eine begrenzte Zeit auch bei starker Hitzeeinwirkung, z.B. bei einem Brand, voll funktionsfähig zu halten. Das gilt vor allem für sicherheitskritische Geräte in feuergefährdeten Bereichen wie Treibstofflagern, Motoren oder Triebwerken von Flugzeugen. Es ist häufig nicht möglich, solche elektronischen Geräte außerhalb eines feuergefährdeten Bereichs anzuordnen.

Ein Schutz vor Hitzeeinwirkung könnte durch Wärmeisolation erfolgen. Zu diesem Zweck könnten an dem elektronischen Gerät Isolationsmaterialien angebracht werden. Das elektronische Gerät könnte auch in einem zusätzlichen feuergeschützten Gehäuse untergebracht sein.

Ein hitzegeschütztes elektronisches Gerät der eingangs genannten Art ist aus der GB 2 151 410 A in Form eines Flugdatenspeichers für ein Flugzeug bekannt. Darin ist ein mechanisch widerstandsfähiges Gehäuse mit einer inneren Verkleidung aus einem hochschmelzenden Material geringer Wärmeleitfähigkeit vorgesehen, innerhalb dessen Leiterplatten mit Festkörperspeichern angeordnet sind, die vorzugsweise von einem weiteren Mantel umgeben sind. Das hochschmelzende Material geringer Wärmeleitfähigkeit schmilzt erst bei Temperaturen von ca. 1100°C und hält den Flugdatenspeicher über mehr als 4 Stunden auf einer Temperatur unter bzw. bis zu 200°C bei Einwirkung von Feuer.

Das bekannte hitzegeschützte elektronische Gerät ist zwar gegen Hitzeeinwirkung von außen thermisch isoliert. Viele elektronische Geräte erzeugen jedoch im Betrieb Verlustwärme in einer solchen Größenordnung, daß eine Abführung der Verlustwärme unerläßlich ist. Wenn diese Wärmeabführung durch Isolationsmaterial oder ein hitzegeschütztes Gehäuse verhindert wird, besteht die Gefahr einer Selbstüberhitzung des elektronischen Geräts. Ein hitzegeschütztes Gehäuse kann gegebenenfalls auch einen erhöhten Raumbedarf und ein erhöhtes Gewicht des elektronischen Geräts mit sich bringen. Das ist insbesondere bei Anwendungen in Flugzeugen ein schwerwiegender Nachteil.

Zur Abführung von Verlustwärme, die beim Betrieb eines elektronischen Gerätes entsteht, ist es beispielsweise aus der DE-AS 11 35 065 bekannt, das Chassis des elektronischen Gerätes mit einem Gehäuse zu verbinden, das an der Bodenfläche und in den Seitenflächen Luftdurchtrittsöffnungen enthält, wobei der Durchtrittsquerschnitt der Öffnungen in der Bodenfläche durch eine bimetallgesteuerte Platte steuerbar ist. Auf diese Weise wird ein an die erzeugte Verlustwärme angepaßter Kühlluftstrom durch das Gehäuse erzeugt. Aus dem DE-GM 75 05 337 ist bekannt, Einschubträger für Leiterplatten an den oberen und unteren Flächen mit Lüftungsschlitzen zu versehen.

Der Erfindung liegt die Aufgabe zugrunde, eine Hitzeschutz-Einrichtung der eingangs genannten Art so auszubilden, daß bei Normalbetrieb eine ausreichende Wärmeabfuhr der in dem elektronischen Gerät selbst erzeugten Verlustwärme erfolgt, daß aber bei starker Hitzeeinwirkung von außen, etwa durch Feuer, ein Hitzeschutz jedenfalls für eine vorgegebene, begrenzte Zeit gewährleistet ist.

Erfindungsgemäß wird diese Aufgabe bei einem Hitzeschutzmantel dadurch gelöst, daß
(a) der Hitzeschutzmantel mit einer Beschichtung versehen ist, die bei Hitzeeinwirkung unter Ausbildung einer wärmeisolierenden Schicht anschwillt, deren Dicke ein Vielfaches der Dicke der ursprünglichen Beschichtung beträgt und welche die Durchbrüche verschließt.

Nach der Erfindung wird diese Aufgabe bei einem hitzegeschützten elektronischen Gerät dadurch gelöst, daß
(a) der Hitzeschutzmantel mit einer Beschichtung versehen ist, die bei Hitzeeinwirkung unter Ausbildung einer wärmeisolierenden Schicht anschwillt, deren Dicke ein Vielfaches der Dicke der ursprünglichen Beschichtung beträgt und welche die Durchbrüche verschließt.

Auf diese Weise kann im Normalbetrieb eine wärmeabführende Luftkonvektion stattfinden. Durch Hitzeeinwirkung schwillt das Material der Beschichtung durch eine chemische Reaktion an. Dabei werden zum einen die Durchbrüche im Hitzeschutzmantel verschlossen. Zum anderen bildet das angeschwollene Material eine feuerhemmende Isolierschicht, welche das electronische Gerät für eine begrenzte Zeit vor der Hitzeeinwirkung schützt. Die von dem elektronischen Gerät selbst erzeugte Verlustwärme kann dann zwar nicht mehr abgeführt werden. Es dauert dann aber üblicherweise doch noch einige Zeit, bis die Funktion des elektronischen Gerätes durch Selbstüberhitzung beeinträchtigt wird. Es hat sich gezeigt, daß durch die beschriebenen Maßnahmen ein wirksamer Hitzeschutz für das elektronische Gerät erzielbar ist.

Vorteilhafterweise besteht der Hitzeschutzmantel aus perforiertem Blech. Das perforierte Blech kann innenseitig wie außenseitig mit der unter Hitzeeinwirkung anschwellenden Beschichtung versehen sein.

Zur Verhinderung der Ausbreitung von Feuer in Gebäuden durch die Kaminwirkung der in Gehäusedächern enthaltenen Belüftungskanäle ist in der DE 39 27 198 A1 vorgeschlagen worden, die Belüftungskanäle durch eine Unterspannbahn in einen oberen und einen unteren Belüftungskanal zu unterteilen. An der Unterspannbahn sind streifenförmige Materialstücke aus unter Wärmeeinwirkung aufschäumenden Streifen angebracht, die parallel zur Traufe verlaufen. Bei Feuereinwirkung aus dem Inneren des Gebäudes schäumen die Materialstreifen auf und verschließen sowohl den unteren wie auch den oberen Belüftungskanal und verhindern dadurch die unerwünschte Kaminwirkung.

Ein Ausführungsbeispiel der Erfindung ist nachstehend unter Bezugnahme auf die zugehörigen Zeichnungen näher erläutert.
- Fig.1: ist eine aufgeschnittene perspektivische Darstellung eines Ausführungsbeispiels des hitzegeschützten elektronischen Gerätes nach der Erfindung;
- Fig.2: ist eine Schnittdarstellung des oberen Teils des hitzegeschützten elektronischen Gerätes nach Fig.1 im Normalbetrieb des elektronischen Geräts; und
- Fig.3: ist eine Schnittdarstellung des oberen Teils des hitzegeschützten elektronischen Gerätes entsprechend Figur 2 bei starker Hitzeeinwirkung.

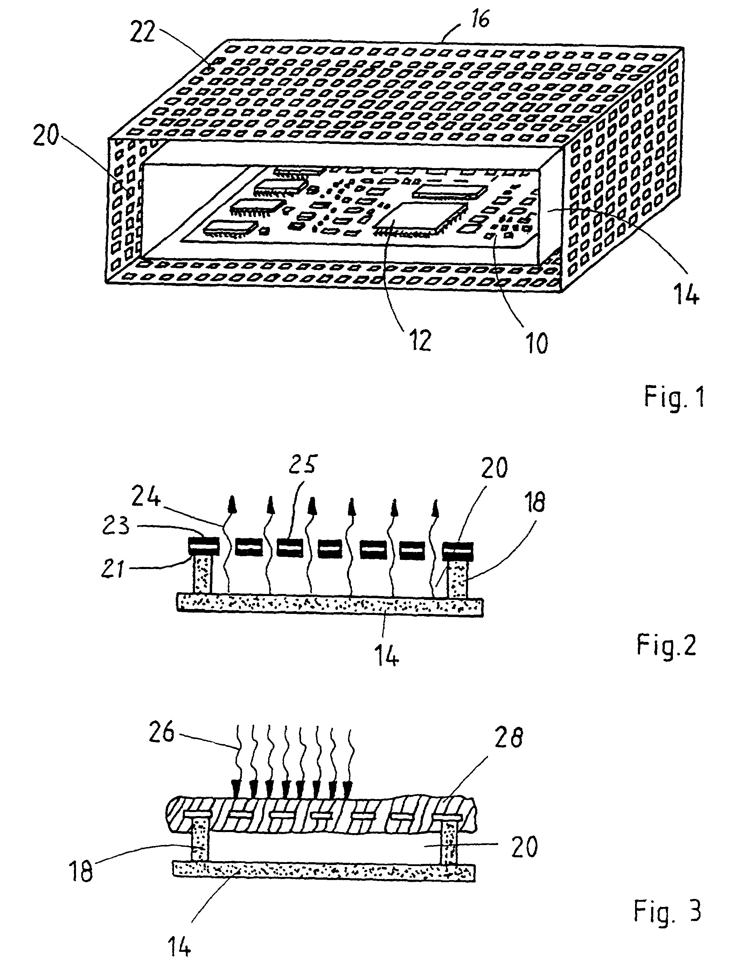

Bei der Anordnung nach Fig.1 ist mit 10 ein hitzegeschütztes elektronisches Gerät bezeichnet, das auch Verlustwärme erzeugende elektronische Bauteile 12 wie beispielsweise Halbleiterbauteile, Leistungstransistoren, passive und aktive Bauelemente oder dergleichen auf einer Leiterplatte enthält. Das elektronische Gerät 10 befindet sich in einem Gehäuse 14, das zum Beispiel aus Metall wie Aluminium oder faserverstärktem Kunststoff bestehen kann. Die Verlustwärme der Bauteile 12 wird in bekannter Weise durch Wärmeleitung und/oder Wärmestrahlung zu dem Gehäuse 14 abgeleitet.

Das Gehäuse 14 ist im Abstand von einem Hitzeschutzmantel 16 umgeben. Der Hitzeschutzmantel 16 ist durch Distanzstükke 18 vorzugsweise allseits im Abstand von dem Gehäuse 14 gehalten, sodaß zwischen dem Gehäuse 14 und dem Hitzeschutzmantel 16 ein Zwischenraum entsteht. Der Hitzeschutzmantel 16 besteht beispielsweise aus Metall wie Stahl oder Aluminium oder einem zum Beispiel durch Glas- oder Kohlefasern verstärkten Kunststoff und ist mit Durchbrüchen 22 versehen. Auf der dem Gehäuse 14 zugekehrten Innenseite 21 wie vorzugsweise auch auf der vom Gehäuse 14 abgekehrten Außenseite 23 ist der Hitzeschutzmantel 16 mit einer Beschichtung 25 aus einem Material versehen, das bei Hitzeeinwirkung, zum Beispiel durch ein Feuer, anschwillt. Solche Materialien finden in der Luft- und Raumfahrt Anwendung.

Wie aus Fig.2 ersichtlich ist, erfolgt die Ableitung der von den elektronischen Bauteilen 12 an das Gehäuse 14 abgegebenen Verlustwärme durch Luftkonvektion durch die Durchbrüche 22 im Hitzeschutzmantel 16. Das ist in Fig.2 durch die Pfeile 24 angedeutet.

Bei Einwirkung von äußerer Hitze, wie in Fig.3 durch Pfeile 26 angedeutet ist, schwillt das Material der auf den Hitzeschutzmantel 16 aufgebrachten Beschichtung 25 stark an, wie in Fig.3 auch dargestellt ist. Das Material bildet dann eine wärmeisolierende Schicht 28, deren Dicke ein Vielfaches der Dicke der ursprünglichen Beschichtung 25 beträgt. Diese Schicht 28 verschließt die Durchbrüche 22 des Hitzeschutzmantels 16 und bildet eine rings im Abstand um das Gehäuse 14 verlaufende, durchgehende, geschlossene, wärmeisolierende Schicht. Zwischen dieser wärmeisolierenden Schicht 28 und dem Gehäuse 14 verbleibt ein Zwischenraum 20 mit einem Luftpolster, welches wärmedämmend wirkt.

In diesem Zustand bleibt das elektronische Gerät 10 wenigstens für eine bestimmte Zeit gegen Hitzeeinwirkung geschützt. Es erfolgt dann zwar keine Abfuhr der Verlustwärme mehr von dem elektronischen Gerät 10. Trotzdem bleibt das elektronische Gerät 10 noch für einige Zeit voll funktionsfähig, bevor seine Funktion durch Selbstüberhitzung beeinträchtigt wird. Im Normalbetrieb erfolgt aber eine praktisch ungestörte Wärmeabfuhr durch Luftkonvektion von dem Gehäuse 14 durch die Durchbrüche 22 im Hitzeschutzmantel 16. Die Vorteile des vorstehend beschriebenen hitzegeschützten elektronischen Gerätes 10 sind beispielsweise in Verbindung mit Triebwerksreglern von Flugzeugen ersichtlich, die üblicherweise direkt an den Triebwerken angebracht sind.

Der Hitzeschutzmantel 16 ist leicht. Der dafür erforderliche zusätzliche Raumbedarf ist gering. Ein zusätzlicher Raumbedarf tritt nur durch den Zwischenraum auf, der zwischen dem Gehäuse 14 und dem Hitzeschutzmantel 16 entsteht.

## Patentansprüche

1. Hitzeschutzmantel (16) für ein Verlustwärme erzeugendes elektronisches Gerät, der Durchbrüche (22) zur wärmeabführenden Luftkonvektion aufweist, **dadurch gekennzeichnet, daß**
(a) der Hitzeschutzmantel (16) mit einer Beschichtung (25) versehen ist, die bei Hitzeeinwirkung unter Ausbildung einer wärmeisolierenden Schicht (28) anschwillt, deren Dicke ein Vielfaches der Dicke der ursprünglichen Beschichtung (25) beträgt und welche die Durchbrüche (22) verschließt.

2. Hitzeschutzmantel nach Anspruch 1, **dadurch gekennzeichnet, daß** der Hitzeschutzmantel (16) innenseitig und außenseitig mit der Beschichtung (25) versehen ist.

3. Hitzeschutzmantel nach Anspruch 1 oder 2, **dadurch gekennzeichnet, daß** Distanzstücke (18) zur Einstellung eines Abstandes zu einem von dem Hitzeschutzmantel (16) eingeschlossenen elektronischen Gerät (10) vorgesehen sind.

4. Hitzeschutzmantel nach einem der vorstehenden Ansprüche, **dadurch gekennzeichnet, daß** der Hitzeschutzmantel (16) aus perforiertem Blech besteht.

5. Hitzeschutzmantel nach einem der Ansprüche 1 bis 4, **dadurch gekennzeichnet, daß** der Hitzeschutzmantel (16) aus einem faserverstärkten Kunststoff besteht.

6. Hitzegeschütztes elektronisches Gerät in einem Gehäuse (14), das von einem Hitzeschutzmantel (16) umgeben ist, wobei
das elektronische Gerät (10) wenigstens ein Verlustwärme erzeugendes elektronisches Bauteil (12) enthält;
von dem Gehäuse (14) die Verlustwärme ableitbar ist;
der Hitzeschutzmantel (16) mit Durchbrüchen (22) zur wärmeabführenden Luftkonvektion versehen ist, **dadurch gekennzeichnet, daß**
(a) der Hitzeschutzmantel (16) mit einer Beschichtung (25) versehen ist, die bei Hitzeeinwirkung unter Ausbildung einer wärmeisolierenden Schicht (28) anschwillt, deren Dicke ein Vielfaches der Dicke der ursprünglichen Beschichtung (25) beträgt und welche die Durchbrüche (22) verschließt.

7. Elektronisches Gerät nach Anspruch 6, **dadurch gekennzeichnet, daß** das Gehäuse (14) wärmeleitend ist und die von dem wenigstens einen elektronischen Baustein (12) erzeugte Verlustwärme von diesem auf das Gehäuse (14) ableitbar ist.

8. Elektronisches Gerät nach Anspruch 6 oder 7, **dadurch gekennzeichnet, daß** der Hitzeschutzmantel (16) an seiner dem elektronischen Gerät (10) zugekehrten Innenseite und an der von dem elektronischen Gerät (10) abgekehrten Außenseite mit der Beschichtung (25) versehen ist.

9. Elektronisches Gerät nach einem der Ansprüche 6 bis 8, **dadurch gekennzeichnet, daß** Distanzstücke vorgesehen sind, welche den Hitzeschutzmantel (16) im Abstand von dem elektronischen Gerät (10) halten.

10. Elektronisches Gerät nach Anspruch 9, **dadurch gekennzeichnet, daß** der Hitzeschutzmantel (16) das elektronische Gerät (10) allseitig umgibt.

11. Elektronisches Gerät nach einem der vorstehenden Ansprüche, **dadurch gekennzeichnet, daß** der Hitzeschutzmantel (16) aus perforiertem Blech besteht.

12. Elektronisches Gerät nach einem der vorstehenden Ansprüche, **dadurch gekennzeichnet, daß** der Hitzeschutzmantel (16) aus faserverstärktem Kunststoff besteht.

## Claims

1. Heat protective casing (16) for an electronic device generating a dissipation heat, having apertures (22) for heat dissipating air convection, **characterised in that**
(a) the heat protective casing (16) is provided with a coating (25) which is swelling with heat effect by forming a heat insulating layer (28) the thickness of which is a multiple of the thickness of the original coating (25) and closing the apertures (22).

2. Heat protective casing as set forth in claim 1 **characterised in that** the heat protective casing (16) is provided with a coating on the inner side and on the outer side.

3. Heat protective casing as set forth in claim 1 or 2 **characterised in that** spacers (18) are provided for adjusting a spacing from an electronic device (10) enclosed by the heat protective casing (16).

4. Heat protective casing as set forth in one of the above claims **characterised in that** the heat protective casing (16) is made of perforated sheet metal.

5. Heat protective casing as set forth in one of claims 1 to 4, **characterised in that** the heat protective casing (16) is made of fibre reinforced plastics.

6. Heat protected electronic device in a housing (14), surrounded by a heat protective casing (16),
the electronic device (10) comprising at least one electronic component generating a dissipation heat;
the dissipation heat being adapted to be dissipated from the housing (14);
the heat protective casing (16) being provided with apertures (22) for heat dissipating air convection, **characterised in that**
(a) the heat protective casing (16) is provided with a coating (25) which is swelling with heat effect by forming a heat insulating layer (28) the thickness of which is a multiple of the thickness of the original coating (25) and closing the apertures (22).

7. Electronic device as set forth in claim 6, **characterised in that** the housing (14) is heat conductive and the dissipation heat generated by the at least one electronic component (12) is adapted to be dissipated therefrom onto the housing (14).

8. Electronic device as set forth in claim 6 or 7, **characterised in that** the heat protective casing (16) is provided with the coating (25) on its inner side facing the electronic device (10) and on the outer side remote from the electronic device (10).

9. Electronic device as set forth in one of claims 6 to 8, **characterised in that** spacers are provided, which spacers keep the heat protective casing (16) spaced from the electronic device (10).

10. Electronic device as set forth in claim 9, **characterised in that** the heat protective casing (16) is surrounding the electronic device (10) on all sides.

11. Electronic device as set forth in one of the above claims, **characterised in that** the heat protective casing (16) is made of perforated sheet metal.

12. Electronic device as set forth in one of the above claims, **characterised in that** the heat protective casing (16) is made of fibre reinforced plastics.

## Revendications

1. Enveloppe de protection thermique (16) pour un appareil électronique générant de la chaleur excédentaire présentant des percements (22) destinés à la convection de l'air dissipant la chaleur, **caractérisée par le fait que**
(a) l'enveloppe de protection thermique (16) est pourvue d'un revêtement (25) qui gonfle sous l'effet de la chaleur en formant une couche d'isolation thermique (28) dont l'épaisseur correspond à plusieurs fois l'épaisseur du revêtement d'origine (25) et qui obstrue les percements (22).

2. Enveloppe de protection thermique selon la revendication 1, **caractérisée par le fait que** l'enveloppe de protection thermique (16) est pourvue à l'intérieur et à l'extérieur du revêtement (25).

3. Enveloppe de protection thermique selon la revendication 1 ou 2, **caractérisée par le fait que** des pièces d'écartement (18) destinées à ajuster l'écart par rapport à un appareil électronique (10) enfermé par l'enveloppe de protection thermique (16) sont prévus.

4. Enveloppe de protection thermique selon l'une des revendications précédentes, **caractérisée par le fait que** l'enveloppe de protection thermique (16) se compose de tôle perforée.

5. Enveloppe de protection thermique selon l'une des revendications 1 à 4, **caractérisée par le fait que** l'enveloppe de protection thermique (16) se compose d'une matière synthétique renforcée par fibres.

6. Appareil électronique à protection thermique situé dans un boîtier (14) entouré d'une enveloppe de protection thermique (16),
l'appareil électronique (10) comprenant au moins un composant électronique (12) générant de la chaleur excédentaire ;
la chaleur excédentaire étant susceptible d'être évacuée par le boîtier (14) ;
l'enveloppe de protection thermique (16) étant pourvue de percements (22) destinés à la convection de l'air dissipant la chaleur, **caractérisé par le fait que**
(a) l'enveloppe de protection thermique (16) est pourvue d'un revêtement (25) qui gonfle sous l'effet de la chaleur en formant une couche d'isolation thermique (28) dont l'épaisseur correspond à plusieurs fois l'épaisseur du revêtement d'origine (25) et qui obstrue les percements (22).

7. Appareil électronique selon la revendication 6, **caractérisé par le fait que** le boîtier (14) conduit la chaleur et la chaleur excédentaire générée par au moins un composant électronique (12) est susceptible d'être transmise par celui-ci au boîtier (14).

8. Appareil électronique selon la revendication 6 ou 7, **caractérisé par le fait que** l'enveloppe de protection thermique (16) est pourvue du revêtement (25) sur son côté intérieur faisant face à l'appareil électronique (10) et sur son côté extérieur opposé à l'appareil électronique (10).

9. Appareil électronique selon l'une des revendications 6 à 8, **caractérisé par le fait que** des pièces d'écartement maintenant l'enveloppe de protection thermique (16) écartée de l'appareil électronique (10) sont prévues.

10. Appareil électronique selon la revendication 9, **caractérisé par le fait que** l'enveloppe de protection thermique (16) entoure l'appareil électronique (10) de tous les côtés.

11. Appareil électronique selon l'une des revendications précédentes, **caractérisé par le fait que** l'enveloppe de protection thermique (16) se compose de tôle perforée.

12. Appareil électronique selon l'une des revendications précédentes, **caractérisé par le fait que** l'enveloppe de protection thermique (16) se compose de matière synthétique renforcée par fibres.
